# EUROPÄISCHE PATENTSCHRIFT

(11) **EP 3 365 923 B1**
(45) Veröffentlichungstag und Bekanntmachung des Hinweises auf die Patenterteilung: **28.04.2021**
(21) Anmeldenummer: 16784878.7
(22) Anmeldetag: 19.10.2016
(51) Int. Cl.: H01L 33/30, H01L 33/40, H01L 33/44, H01L 33/00, H01L 33/14, H01L 33/20, H01L 33/38, H01L 33/46

(54) **LEUCHTDIODENCHIP UND DESSEN HERSTELLUNGSVERFAHREN**
LIGHT-EMITTING DIODE CHIP AND METHOD FOR PRODUCING THE SAME
PUCE DE DIODE ÉLECTROLUMINESCENTE ET SON PROCÉDÉ DE FABRICATION

(30) Priorität: 22.10.2015 DE 102015118041
(43) Veröffentlichungstag der Anmeldung: 29.08.2018
(73) Patentinhaber: OSRAM Opto Semiconductors GmbH, 93055 Regensburg (DE)
(72) Erfinder: BAUR, Johannes, 93051 Regensburg (DE)
(74) Vertreter: Epping - Hermann - Fischer
(86) Internationale Anmeldenummer: PCT/EP2016/075092
(87) Internationale Veröffentlichungsnummer: WO 2017/067983

(56) Entgegenhaltungen:
- DE-A1-102008 048 648
- DE-A1-102013 100 818
- DE-A1-102013 103 079
- DE-T5-112012 006 689
- US-A1- 2009 072 257
- US-A1- 2012 098 016
- US-A1- 2012 326 178
- US-A1- 2014 061 702

## Beschreibung

Es wird ein Leuchtdiodenchip angegeben. Darüber hinaus wird ein Verfahren zur Herstellung eines Leuchtdiodenchips angegeben.
Die Druckschrift US 2009/0072257 A1 betrifft eine LED.
Aus den Druckschriften US 2012/0098016 A1, DE 11 2012 006 689 T5, DE 10 2013 100 818 A1, DE 10 2013 103 079 A1 und US 2012/0326178 A1 sind jeweils LED-Chips mit einer Verkapselungsschicht, die mittels Atomlagenabscheidung erzeugt wurde, bekannt.
Ein optoelektronisches Halbleiterbauteil findet sich in der Druckschrift US 2014/0061702 A1.

In der Druckschrift DE 10 2008 048 648 A1 ist ein optoelektronischer Halbleiterchip offenbart.
Eine zu lösende Aufgabe besteht darin, Leuchtdiodenchips mit einer hohen Effizienz und einer hohen Lebensdauer anzugeben. Diese Aufgabe wird durch einen Leuchtdiodenchip mit den Merkmalen des Patentanspruchs 1 gelöst. Bevorzugte Weiterbildungen sind Gegenstand der übrigen Ansprüche.

Erfindungsgemäß umfasst der Leuchtdiodenchip eine Halbleiterschichtenfolge. Die Halbleiterschichtenfolge weist mindestens eine aktive Zone auf, die im Betrieb des Leuchtdiodenchips zur Erzeugung von Strahlung eingerichtet ist. Die erzeugte Strahlung ist bevorzugt inkohärent. Die Halbleiterschichtenfolge basiert bevorzugt auf einem III-V-Verbindungshalbleitermaterial. Bei dem Halbleitermaterial handelt es sich um AlₙGaₘIn₁₋ₙ₋ₘAsₖP₁₋ₖ, wobei 0 ≤ n ≤ 1, 0 ≤ m ≤ 1 und n + m ≤ 1 sowie 0 ≤ k < 1 ist. Bevorzugt gilt dabei für zumindest eine Schicht oder für alle Schichten der Halbleiterschichtenfolge 0 < n ≤ 0,8, 0,4 ≤ m < 1 und n + m ≤ 0,95 sowie 0 < k ≤ 0,5. Dabei kann die Halbleiterschichtenfolge Dotierstoffe sowie zusätzliche Bestandteile aufweisen. Der Einfachheit halber sind jedoch nur die wesentlichen Bestandteile des Kristallgitters der Halbleiterschichtenfolge, also Al, As, Ga, In oder P, angegeben, auch wenn diese teilweise durch geringe Mengen weiterer Stoffe ersetzt und/oder ergänzt sein können.

Beispielsweise wird im Betrieb der Halbleiterschichtenfolge grünes, gelbes oder rotes Licht erzeugt. Grünes Licht bezieht sich dabei insbesondere auf eine Dominanzwellenlänge des emittierten Lichts zwischen einschließlich 500 nm und 540 nm, gelbes Licht auf einen Wellenlängenbereich zwischen 560 nm und 580 nm und rotes Licht beispielsweise auf einen Wellenlängenbereich für die Dominanzwellenlänge von 600 nm bis 700 nm.

Erfindungsgemäß basiert die Halbleiterschichtenfolge auf dem Materialsystem InGaAlP oder InGaAlAsP. Das heißt bevorzugt, die Halbleiterschichtenfolge umfasst als Hauptbestandteile In, Ga, Al sowie P oder In, Ga, Al, As sowie P. In diesem Fall ist die Halbleiterschichtenfolge insbesondere zur Erzeugung von rotem Licht oder zur Erzeugung von nahinfraroter Strahlung eingerichtet. Nahinfrarote Strahlung bezeichnet beispielsweise eine Strahlung mit einer Wellenlänge maximaler Intensität zwischen einschließlich 800 nm und 1500 nm.

Erfindungsgemäß umfasst der Leuchtdiodenchip eine Stromaufweitungsschicht. Die Stromaufweitungsschicht dient dazu, in Richtung senkrecht zu einer Wachstumsrichtung der Halbleiterschichtenfolge und somit in einer lateralen Richtung eine Stromaufweitung zu erzielen. Speziell ausgehend von punktartigen elektrischen Kontaktflächen wird von der Stromaufweitungsschicht eine Stromspreizung in lateraler Richtung bewirkt.

Erfindungsgemäß befindet sich die Stromaufweitungsschicht direkt an der Halbleiterschichtenfolge. Beispielsweise ist die Stromaufweitungsschicht direkt auf die Halbleiterschichtenfolge aufgewachsen, insbesondere epitaktisch aufgewachsen. Die Halbleiterschichtenfolge und die Stromaufweitungsschicht können im selben Wachstumsreaktor unmittelbar nacheinander ohne Zwischenschritte mit derselben Methode erzeugt werden.

Die Stromaufweitungsschicht ist ebenfalls aus einem Halbleitermaterial gebildet. Vorliegend wird die Stromaufweitungsschicht jedoch rein begrifflich von der Halbleiterschichtenfolge getrennt. So bezieht sich der Begriff Halbleiterschichtenfolge auf die zur Lichterzeugung eingerichteten Schichten, wohingegen der Begriff Stromaufweitungsschicht auf eine laterale Stromaufspreizung als Hauptfunktion dieser Schicht abzielt.

Erfindungsgemäß basiert die Stromaufweitungsschicht auf einem anderen Materialsystem als die Halbleiterschichtenfolge. Insbesondere ist bei der Halbleiterschichtenfolge eine Hauptkomponente eines Kristallgitters Phosphor. Mit anderen Worten basiert die Halbleiterschichtenfolge dann auf einem Phosphid. In diesem Fall handelt es sich bei der Stromaufweitungsschicht um ein Arsenid. Erfindungsgemäß basiert die Stromaufweitungsschicht auf dem Materialsystem AlGaAs.

Erfindungsgemäß beinhaltet der Leuchtdiodenchip zumindest eine Verkapselungsschicht. Die Verkapselungsschicht ist dazu eingerichtet, etwa die Stromaufweitungsschicht vor einer Beschädigung, zum Beispiel durch Feuchtigkeit, zu schützen. Insbesondere AlGaAs neigt dazu, sich bei Einwirken von Feuchtigkeit zu zersetzen und damit die Funktionsfähigkeit des Leuchtdiodenchips zu beeinträchtigen. Durch die Verkapselungsschicht sind solche Schäden an der Stromaufweitungsschicht reduzierbar.

Erfindungsgemäß befindet sich die Verkapselungsschicht stellenweise direkt auf der Stromaufweitungsschicht und/oder auf der Halbleiterschichtenfolge. Die Verkapselungsschicht bedeckt alle freiliegenden Seitenflächen der Halbleiterschichtenfolge und/oder der Stromaufweitungsschicht. Freiliegend bedeutet hierbei insbesondere, dass entsprechende Flächen nicht von Halbleitermaterialien oder von Strom führenden Materialien bedeckt sind.

Erfindungsgemäß weist die Verkapselungsschicht eine mittlere Dicke auf, die mindestens 10 nm oder 20 nm oder 30 nm beträgt. Zusätzlich liegt die mittlere Dicke der Verkapselungsschicht bei höchstens 200 nm oder 150 nm oder 90 nm. Insbesondere beträgt die mittlere Dicke ungefähr 40 nm oder 70 nm.

Erfindungsgemäß weist die Verkapselungsschicht eine mittlere Defektdichte von höchstens 10/mm² oder 1/mm² oder 0,1/mm² auf. Solche sehr geringen Defektdichten führen zu einer hohen Dichtigkeit der Verkapselungsschicht. Dies ist dadurch erzielbar, dass die Verkapselungsschicht über Atomlagenabscheidung erzeugt wird.

Eine Atomlagenabscheidung, englisch Atomic Layer Deposition oder kurz ALD, ist etwa in der Druckschrift US 4,058,430 A angegeben.

Gemäß zumindest einer Ausführungsform weist die Verkapselungsschicht eine spezifische Diffusionskonstante für Wasser und/oder Sauerstoff von höchstens 10⁻⁵ g/(m² d) auf. Die spezifische Diffusionskonstante ist insbesondere gerechnet auf eine Materialdicke von 100 nm. Bevorzugt beträgt die Diffusionskonstante höchstens 5 x 10⁻⁶ g/(m² d), insbesondere höchstens 10⁻⁶ g/(m² d).

Erfindungsgemäß umfasst der Leuchtdiodenchip eine oder mehrere Abdeckschichten. Die zumindest eine Abdeckschicht ist ganzflächig oder stellenweise direkt auf die Verkapselungsschicht aufgebracht. Die Abdeckschicht ist bevorzugt undurchlässig für Flüssigkeiten. Insbesondere ist die Abdeckschicht undurchlässig für Wasser in flüssiger Form. Die Abdeckschicht wird bevorzugt über chemische oder physikalische Gasphasenabscheidung, auch als CVD oder PVD bezeichnet, hergestellt.

Erfindungsgemäß umfasst der Leuchtdiodenchip eine oder mehrere Reflexionsschichten. Bei der zumindest einen Reflexionsschicht handelt es sich um eine nichtmetallische Schicht, beispielsweise aus einem elektrisch isolierenden Material. Insbesondere ist die Reflexionsschicht dazu eingerichtet, zu einer Totalreflexion von in der Halbleiterschichtenfolge erzeugter Strahlung zu dienen. Ein Material, aus dem die Reflexionsschicht hergestellt ist, ist bevorzugt transparent für die in der Halbleiterschichtenfolge erzeugte Strahlung. Die Reflexionsschicht ist bevorzugt aus einem Oxid oder Nitrid gebildet.

Erfindungsgemäß befindet sich die Reflexionsschicht an einer der Halbleiterschichtenfolge abgewandten Seite der Stromaufweitungsschicht. Dabei kann die Reflexionsschicht direkt an die Stromaufweitungsschicht grenzen. Ebenso ist es möglich, dass die Reflexionsschicht von der Stromaufweitungsschicht beabstandet aufgebracht ist.

Erfindungsgemäß befindet sich die Reflexionsschicht stellenweise direkt an der Verkapselungsschicht. Insbesondere bedeckt die Verkapselungsschicht Seitenflächen der Reflexionsschicht.

Gemäß zumindest einer Ausführungsform befindet sich zumindest eine Stromleitschicht an einer der Stromaufweitungsschicht abgewandten Seite der Reflexionsschicht. Die Stromleitschicht ist bevorzugt zu einer ohmschen Stromleitung in Richtung senkrecht zur aktiven Zone eingerichtet. Insbesondere ist die mindestens eine Stromleitschicht aus einem Metall oder einem elektrisch leitfähigen Oxid, auch als TCO bezeichnet, hergestellt.

Gemäß zumindest einer Ausführungsform ist die Stromleitschicht dazu eingerichtet, eine Stromführung hin zu zumindest einer elektrischen Kontaktfläche zu bewirken.

Beispielsweise werden alle Kontaktflächen für einen bestimmten Anschlusstyp, zum Beispiel für einen p-Kontakt oder für einen n-Kontakt, durch die Stromleitschicht mit Strom versorgt. Bevorzugt ist die mindestens eine Stromleitschicht oder ist zumindest eine der Stromleitschichten aus einem für die in der Halbleiterschichtenfolge erzeugten Strahlung undurchlässigen und reflektierenden Material gebildet. Mit anderen Worten kann zumindest eine der Stromleitschichten einen Spiegel für die erzeugte Strahlung bilden. Ferner kann eine weitere Stromleitschicht eine Haftvermittlungsschicht bilden.

Erfindungsgemäß umfasst der Leuchtdiodenchip eine Halbleiterschichtenfolge, die auf InGaAlAsP, bevorzugt auf InGaAlP, basiert und die zur Erzeugung von sichtbarem Licht oder nahinfraroter Strahlung eingerichtet ist. Eine Stromaufweitungsschicht befindet sich direkt an der Halbleiterschichtenfolge und basiert auf AlGaAs. Eine Verkapselungsschicht ist stellenweise direkt auf der Stromaufweitungsschicht und/oder auf der Halbleiterschichtenfolge aufgebracht. Eine mittlere Dicke der Verkapselungsschicht liegt zwischen einschließlich 10 nm und 200 nm und eine Defektdichte der Verkapselungsschicht beträgt höchstens 10/mm².

Auf der Verkapselungsschicht ist zumindest stellenweise direkt wenigstens eine Abdeckschicht aufgebracht. An einer der Halbleiterschichtenfolge abgewandten Seite der Stromaufweitungsschicht befindet sich in direktem oder in indirektem Kontakt zumindest eine nichtmetallische Reflexionsschicht, die zur Totalreflexion von Strahlung eingerichtet ist. Die zumindest eine Reflexionsschicht ist stellenweise direkt oder indirekt von der Verkapselungsschicht bedeckt, beispielsweise an einer Hauptseite oder an einer Seitenfläche. An einer der Stromaufweitungsschicht abgewandten Seite der Reflexionsschicht befindet sich in direktem oder indirektem Kontakt stellenweise zumindest eine Stromleitschicht, die als Spiegelschicht und/oder als Haftvermittlungsschicht ausgebildet sein kann oder aus solchen Schichten bestehen kann. Die zumindest eine Stromleitschicht kann direkt an elektrische Kontaktflächen zur Einprägung von Strom in die Halbleiterschichtenfolge grenzen.

Werden Leuchtdiodenchips auf der Basis von InGaAlP in einer feuchten Umgebung gelagert oder betrieben, so tritt bei Schichten aus AlGaAs mit einem hohen Aluminiumgehalt regelmäßig eine Korrosion des AlGaAs auf. Dies kann zu inhomogenen Leuchtbildern und bei starker Ausprägung zu einem Spannungsanstieg und auch zu einem Totalausfall der Leuchtdiodenchips führen. Um dem entgegenzuwirken, besteht eine Möglichkeit darin, eine Schichtdicke der AlGaAs-Schicht möglichst gering zu halten und einen möglichst kleinen Aluminiumgehalt zu wählen.

Ebenso werden AlGaAs-Schichten durch dielektrische Schichten wie Siliziumnitrid oder Siliziumdioxid so gut wie möglich gegen Feuchtezugang geschützt. Solche dielektrischen Schichten sind jedoch nur begrenzt feuchtedicht, sodass eine Alterung des Leuchtdiodenchips nur zeitlich verzögert wird. Andererseits ist eine Anhaftung solcher dielektrischen Schichten an das Halbleitermaterial nur vergleichsweise schlecht. Solche dielektrischen Schichten vermögen daher keine hinreichende Altersstabilisierung zu bewirken. Weiterhin besteht eine Möglichkeit darin, die AlGaAs-Schicht durch GaP als Kontaktmaterial zu ersetzen, um die alterungsanfällige Komponente in solchen Leuchtdiodenchips zu ersetzen.

Bei den hier beschriebenen Leuchtdiodenchips ist eine hinreichend dicke AlGaAs-Schicht verwendbar. Dies wird dadurch erzielt, dass eine mit Atomlagenabscheidung erzeugte, hochdichte Verkapselungsschicht zum Schutz der AlGaAs-Stromaufweitungsschicht verwendet wird. Durch die erhöhte Lebensdauer der Leuchtdiodenchips sind die vergleichsweise hohen Erzeugungskosten für die Verkapselungsschicht durch Atomlagenabscheidung rechtfertigbar.

Gemäß zumindest einer Ausführungsform liegt ein Aluminiumanteil in dem AlGaAs der Stromaufweitungsschicht bei mindestens 20 % oder 40 % oder 60 %. Alternativ oder zusätzlich liegt der Aluminiumanteil bei höchstens 80 % oder 70 % oder 60 %. Beispielsweise bedeutet ein Aluminiumanteil von 50 %, dass 50 % der Gitterplätze von Gallium in dem Kristallgitter GaAs durch Aluminiumatome ersetzt sind. Bevorzugt weist die Stromaufweitungsschicht mehrere Teilschichten mit unterschiedlichem Al-Gehalt auf. Beispielsweise liegt eine dünne Teilschicht aus GaAs vor, gefolgt von einer dickeren Teilschicht aus AlGaAs, wiederum gefolgt von einer noch dickeren AlGaAs-Teilschicht mit höherem Al-Gehalt. Bei einem Leuchtdiodenchip zur Erzeugung von sichtbarem Licht liegt so insbesondere eine 5 nm dicke GaAs-Schicht vor, gefolgt von einer 50 nm-AlGaAs-Schicht mit einem Al-Gehalt von 60 %, gefolgt von einer 200 nm AlGaAs-Schicht mit einem Al-Gehalt von 70 %; die genannten Werte für die Dicke und den Al-Gehalt gelten bevorzugt mit einer Toleranz von höchstens 25 % oder 10 %. Ist der Leuchtdiodenchip zur Erzeugung von infraroter Strahlung eingerichtet, so ist es möglich, dass die Stromaufweitungsschicht aus nur einer einzigen Schicht, etwa aus AlGaAs mit 24 % Al, gebildet ist. Die GaAs-Teilschicht kann der Halbleiterschichtenfolge zugewandt oder von der Halbleiterschichtenfolge abgewandt sein.

Gemäß zumindest einer Ausführungsform ist die Verkapselungsschicht eine Al₂O₃-Schicht. Mit anderen Worten ist die Verkapselungsschicht dann eine homogene Schicht aus Aluminiumoxid. Eine Schichtdicke der Verkapselungsschicht ist bevorzugt über die gesamte Verkapselungsschicht hinweg gleichbleibend.

Erfindungsgemäß weist die Abdeckschicht eine größere mittlere Dicke auf als die Verkapselungsschicht. Beispielsweise liegt die mittlere Dicke der Abdeckschicht bei mindestens 80 nm oder 150 nm oder 200 nm. Alternativ oder zusätzlich beträgt die mittlere Dicke der Abdeckschicht höchstens 1 µm oder 600 nm oder 400 nm.

Erfindungsgemäß bedeckt die Verkapselungsschicht äußere Facetten der Stromaufweitungsschicht vollständig und direkt. Die äußeren Facetten der Stromaufweitungsschicht sind dabei solche Facetten, die am weitesten außen am Leuchtdiodenchip liegen.

Erfindungsgemäß überragen die Reflexionsschicht und optional die zumindest eine Stromleitschicht jeweils die Stromaufweitungsschicht und die Halbleiterschichtenfolge seitlich, in Draufsicht gesehen. Mit anderen Worten kann eine Grundfläche der Reflexionsschicht und/oder eine Grundfläche der Stromleitschicht größer sein als eine Grundfläche der Stromaufweitungsschicht und/oder der Halbleiterschichtenfolge.

Erfindungsgemäß ist die Verkapselungsschicht direkt auf solche Teilgebiete der Reflexionsschicht aufgebracht, die die Stromaufweitungsschicht seitlich überragen. Insbesondere ist die Reflexionsschicht dann an einer der Halbleiterschichtenfolge zugewandten Seite in dem Teilgebiet, das sich neben der Halbleiterschichtenfolge befindet, vollständig von der Verkapselungsschicht bedeckt. Seitenflächen der Reflexionsschicht, die näherungsweise parallel zur Wachstumsrichtung der Halbleiterschichtenfolge orientiert sind, können frei sein von der Verkapselungsschicht.

Gemäß zumindest einer Ausführungsform bedeckt die Verkapselungsschicht äußere Facetten der Stromaufweitungsschicht und/oder der Reflexionsschicht direkt und vollständig. Mit anderen Worten sind dann äußere Begrenzungsflächen der Reflexionsschicht und/oder der Stromaufweitungsschicht durch die Verkapselungsschicht geschützt.

Gemäß zumindest einer Ausführungsform ist die Verkapselungsschicht in Draufsicht gesehen neben der Stromaufweitungsschicht direkt auf eine der Stromleitschichten oder auf die Stromleitschicht aufgebracht. Hierdurch ist eine vollständige Verkapselung der Reflexionsschicht erzielbar. Insbesondere ist es möglich, dass die Reflexionsschicht ringsum vollständig von der Stromaufweitungsschicht zusammen mit der Verkapselungsschicht und der Stromleitschicht umschlossen ist.

Gemäß zumindest einer Ausführungsform umfasst der Leuchtdiodenchip außerdem eine Zusatzverkapselungsschicht. Die Zusatzverkapselungsschicht ist ebenso wie die Verkapselungsschicht mittels Atomlagenabscheidung erzeugt und weist daher, entsprechend der Verkapselungsschicht, eine hohe Beständigkeit gegenüber Diffusion und eine geringe Defektdichte auf.

Gemäß zumindest einer Ausführungsform sind die Zusatzverkapselungsschicht und die Verkapselungsschicht aus demselben Material hergestellt. Insbesondere bestehen beide Schichten aus Al₂O₃. Die Zusatzverkapselungsschicht und die Verkapselungsschicht sind bevorzugt in voneinander verschiedenen Verfahrensschritten hergestellt. Insbesondere finden zwischen dem Erzeugen der Zusatzverkapselungsschicht und der Verkapselungsschicht weitere Verfahrensschritte statt.

Gemäß zumindest einer Ausführungsform ist die Zusatzverkapselungsschicht direkt an einer der Halbleiterschichtenfolge abgewandten Seite der Stromaufweitungsschicht aufgebracht. Diese Seite der Stromaufweitungsschicht kann vollständig von der Zusatzverkapselungsschicht, zusammen mit der elektrischen Kontaktfläche, bedeckt sein.

Gemäß zumindest einer Ausführungsform berühren sich die Zusatzverkapselungsschicht und die Verkapselungsschicht stellenweise. Dabei ist in einem Berührbereich, in dem sich die Zusatzverkapselungsschicht und die Verkapselungsschicht berühren, bevorzugt eine dichte Verkapselung gegeben. Mit anderen Worten weist der Berührbereich dann, im Vergleich etwa zur Verkapselungsschicht, keine erhöhte Durchlässigkeit, etwa für Feuchtigkeit oder Sauerstoff, auf.

Gemäß zumindest einer Ausführungsform steht die Reflexionsschicht an keiner Stelle in direktem Kontakt mit der Halbleiterschichtenfolge und/oder der Stromaufweitungsschicht. Insbesondere befindet sich zwischen der Stromaufweitungsschicht und der Reflexionsschicht ausschließlich die Zusatzverkapselungsschicht, zumindest stellenweise.

Gemäß zumindest einer Ausführungsform sind die Halbleiterschichtenfolge und die Stromaufweitungsschicht ringsum vollständig von der Verkapselungsschicht zusammen mit der optional vorhandenen Zusatzverkapselungsschicht und zusammen mit den elektrischen Kontaktflächen eingeschlossen. Insbesondere ist auch eine Strahlungshauptseite der Halbleiterschichtenfolge, die der Stromaufweitungsschicht abgewandt ist, vollständig von einer elektrischen Kontaktfläche und der Verkapselungsschicht bedeckt. Auf der Strahlungshauptseite kann auch die Abdeckschicht aufgebracht sein.

Gemäß zumindest einer Ausführungsform handelt es sich bei der elektrischen Kontaktfläche um eine Kontaktmetallisierung. Mit anderen Worten ist dann die elektrische Kontaktfläche aus einem Metall oder einer Metalllegierung gebildet. Bevorzugt befinden sich an der Stromaufweitungsschicht mehrere Kontaktflächen aus demselben Material. An der Strahlungsaustrittsseite der Halbleiterschichtenfolge ist bevorzugt eine weitere elektrische Kontaktfläche angebracht. Diese Kontaktfläche an der Strahlungsaustrittsseite kann aus einem anderen, bevorzugt metallischen Material gebildet sein.

Gemäß zumindest einer Ausführungsform ist die Reflexionsschicht zumindest stellenweise in zwei oder mehr als zwei Teilschichten aufgeteilt. Die Teilschichten der Reflexionsschicht folgen entlang der Wachstumsrichtung der Halbleiterschichtenfolge aufeinander.

Gemäß zumindest einer Ausführungsform befindet sich zumindest stellenweise zwischen den zwei Teilschichten der Reflexionsschicht die Verkapselungsschicht und/oder die Zusatzverkapselungsschicht. Hierdurch ist eine effiziente Prozessierbarkeit erzielbar bei gleichzeitig hohem Schutz der Stromaufweitungsschicht vor Feuchtigkeit durch die Verkapselungsschicht und/oder die Zusatzverkapselungsschicht. So kann die Verkapselungsschicht und/oder die Zusatzverkapselungsschicht als Ätzstoppschicht dienen.

Gemäß zumindest einer Ausführungsform stellt die Verkapselungsschicht und/oder die Zusatzverkapselungsschicht eine Ätzstoppschicht für die Stromaufweitungsschicht, die Halbleiterschichtenfolge und/oder die Reflexionsschicht dar. Mit anderen Worten ist in diesem Fall die Stromaufweitungsschicht gegenüber der Verkapselungsschicht und/oder der Zusatzverkapselungsschicht selektiv ätzbar. Eine Ätzselektivität liegt beispielsweise bei mindestens 500:1 oder 10000:1.

Gemäß zumindest einer Ausführungsform durchdringt die Reflexionsschicht die Stromaufweitungsschicht stellenweise vollständig. Mit anderen Worten ist die Stromaufweitungsschicht stellenweise von einer Unterseite der Halbleiterschichtenfolge komplett entfernt. In zumindest einem Teilbereich des Gebiets, aus dem die Stromaufweitungsschicht vollständig entfernt ist, liegt die Reflexionsschicht direkt an der Halbleiterschichtenfolge an. Die Reflexionsschicht kann auch stellenweise in die Halbleiterschichtenfolge eindringen, sodass die Halbleiterschichtenfolge teilweise entfernt ist und Ausnehmungen und/oder Gräben aufweist.

Gemäß zumindest einer Ausführungsform weist die Stromaufweitungsschicht einen äußeren, umlaufenden Rand auf. Dieser umlaufende Rand ist durch ein Material der Reflexionsschicht von einem Zentrum der Stromaufweitungsschicht elektrisch isoliert. Dabei befinden sich die elektrischen Kontaktbereiche für die Stromaufweitungsschicht in dem Zentrum. Durch eine solche Anordnung ist verhinderbar, dass eine Bestromung der aktiven Zone direkt an Facetten der Halbleiterschichtenfolge erfolgt. Hierdurch ist eine Effizienz des Leuchtdiodenchips erhöhbar.

Gemäß zumindest einer Ausführungsform bildet die Reflexionsschicht um die Stromaufweitungsschicht herum einen umlaufenden Rand, in Draufsicht gesehen. In diesem umlaufenden Rand grenzt die Reflexionsschicht bevorzugt direkt an die Halbleiterschichtenfolge und bedeckt äußere Begrenzungsflächen der Stromaufweitungsschicht bevorzugt vollständig.

Gemäß zumindest einer Ausführungsform weist der Rand eine Breite von mindestens 1 µm oder 3 µm oder 5 µm auf. Alternativ oder zusätzlich liegt diese Breite bei höchstens 20 µm oder 15 µm oder 10 µm. Die Breite des Rands macht beispielsweise mindestens 0,1 % oder 0,3 % einer mittleren Kantenlänge der Halbleiterschichtenfolge aus, in Draufsicht gesehen. Ebenso kann der Rand höchstens 3 % oder 1 % oder 0,5 % der mittleren Kantenlänge ausmachen.

Gemäß zumindest einer Ausführungsform befindet sich an einer der Halbleiterschichtenfolge abgewandten Seite der Stromleitschicht ein Träger. Der Träger ist dazu eingerichtet, den Leuchtdiodenchip mechanisch zu stabilisieren und zu tragen. Mit anderen Worten kann es sich bei dem Träger um diejenige Komponente des Leuchtdiodenchips handeln, die diesen mechanisch stützt. Beispielsweise ist der Träger über zumindest ein Lot mechanisch und/oder elektrisch und/oder thermisch direkt mit der Stromleitschicht verbunden.

Gemäß zumindest einer Ausführungsform weist der elektrische Kontaktbereich einen Zentralbereich und einen Randbereich auf. In dem Zentralbereich wird Strom aus dem elektrischen Kontaktbereich in die Stromaufweitungsschicht eingeprägt. In dem Zentralbereich folgen somit die nachfolgend genannten Schichten in der angegebenen Reihenfolge bevorzugt direkt aufeinander: die Stromaufweitungsschicht, eine metallische Kontaktschicht, eine metallische Anhaftschicht und eine erste Stromleitschicht, wobei die erste Stromleitschicht zugleich eine Spiegelschicht ist.

Gemäß zumindest einer Ausführungsform folgen in dem Randbereich die folgenden Schichten in der angegebenen Reihenfolge bevorzugt unmittelbar aufeinander: die Stromaufweitungsschicht, die Kontaktschicht, die Anhaftschicht, die Zusatzverkapselungsschicht, eine zweite Stromleitschicht und die erste Stromleitschicht. Bei der zweiten Stromleitschicht handelt es sich um eine bevorzugt lichtdurchlässige Schicht, etwa aus einem transparenten leitfähigen Oxid wie ITO. Die zweite Stromleitschicht dient bevorzugt als Haftvermittlungsschicht. Bei der ersten Stromleitschicht handelt es sich bevorzugt um eine lichtundurchlässige, metallische Schicht, etwa aus Gold, die als Spiegelschicht dient.

Darüber hinaus wird ein Verfahren gemäß Patentanspruch 12 angegeben, mit dem ein Leuchtdiodenchip gemäß einer oder mehrerer der oben genannten Ausführungsformen hergestellt wird.
Erfindungsgemäß wird die Verkapselungsschicht mittels Atomlagenabscheidung hergestellt. Demgegenüber wird die Abdeckschicht mittels chemischer oder physikalischer Gasphasenabscheidung und im Gegensatz zur Verkapselungsschicht nicht durch Atomlagenabscheidung hergestellt.
Bei der physikalischen Gasphasenabscheidung, auch als PVD bezeichnet, handelt es sich etwa um ein Verdampfungsverfahren, um Sputtern, um Ionenimplantation oder um eine so genannte ICB-Technik (Ionized Cluster Beam Deposition). Bei der chemischen Gasphasenabscheidung handelt es sich beispielsweise um plasmaunterstützte, induktiv oder kapazitiv gekoppelte, heißdrahtaktivierte oder katalytische Gasphasenabscheidung. Die CVD kann bei Niederdruck oder bei atmosphärischem Druck durchgeführt werden. Ebenso kann eine metallorganische oder organometallische chemische Gasphasenabscheidung erfolgen.
Es unterscheiden sich die durch ALD erstellte Verkapselungsschicht und die über CVD oder PVD erzeugte Abdeckschicht dadurch, dass eine Defektdichte bei der ALD-Verkapselungsschicht typisch kleiner als 0,1 Defekte pro Quadratmillimeter beträgt, wohingegen die CVD- oder PVD-Abdeckschicht eine Defektdichte von einigen 100 Defekten pro Quadratmillimeter aufweist. Dies ist beispielsweise über Transmissionselektronenmikroskopie, kurz TEM, nachweisbar. Aufgrund der vergleichsweise geringeren Defektdichte der ALD-Verkapselungsschicht ist auch eine Ätzrate, im Vergleich zur CVD- oder PVD-Abdeckschicht, reduziert. Beispielsweise über die Defektdichte und/oder die Ätzrate ist eindeutig feststellbar, über welche Methode eine Schicht erzeugt wurde. Nachfolgend werden ein hier beschriebener Leuchtdiodenchip und ein hier beschriebenes Verfahren unter Bezugnahme auf die Zeichnung näher erläutert. Gleiche Bezugszeichen geben dabei gleiche Elemente in den einzelnen Figuren an. Es sind dabei jedoch keine maßstäblichen Bezüge dargestellt, vielmehr können einzelne Elemente zum besseren Verständnis übertrieben groß dargestellt sein.

Es zeigen:
- Figuren 1, 4, 5, 7, 10, 13, 14, 15 und 16: schematische Schnittdarstellungen von Ausführungsbeispielen von hier beschriebenen Leuchtdiodenchips,
- Figur 2: eine schematische Schnittdarstellung einer nicht erfindungsgemäßen Abwandlung eines Leuchtdiodenchips,
- Figuren 3, 6, 8, 11 und 12: schematische Schnittdarstellungen von nicht erfindungsgemäßen Abwandlungen von Leuchtdiodenchips,
und
- Figur 9: eine schematische Draufsicht auf eine Stromaufweitungsschicht für Ausführungsbeispiele und Abwandlungen von hier beschriebenen Leuchtdiodenchips.

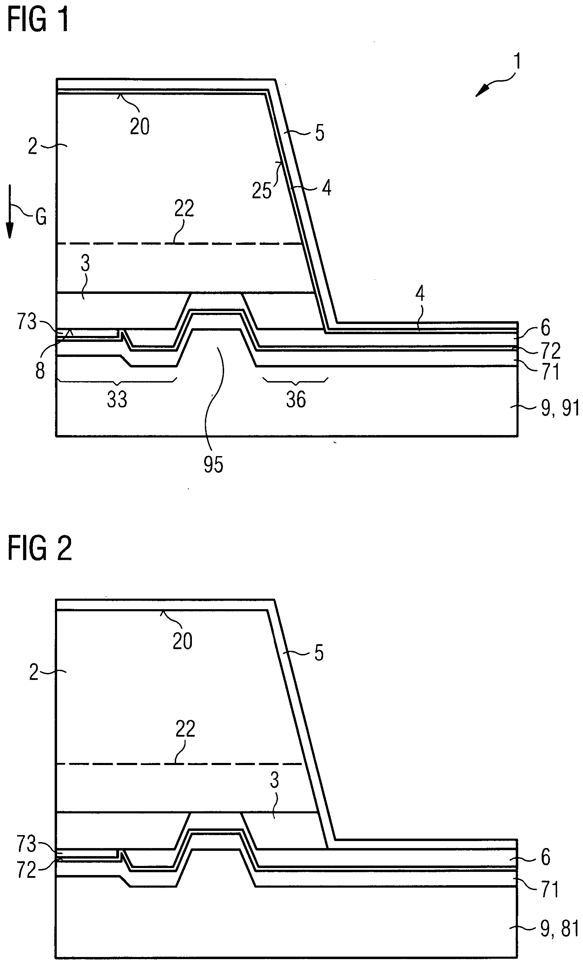

In Figur 1 ist ein Ausführungsbeispiel eines Leuchtdiodenchips 1 gezeigt. Der Leuchtdiodenchip 1 umfasst eine Halbleiterschichtenfolge 2 mit einer aktiven Zone 22. Die Halbleiterschichtenfolge 2 basiert auf dem Materialsystem InGaAlP. Eine in der Halbleiterschichtenfolge 2 im Betrieb des Leuchtdiodenchips 1 erzeugte Strahlung, bevorzugt rotes Licht, tritt überwiegend an einer Strahlungshauptseite 20 aus der Halbleiterschichtenfolge 2 heraus.

An einer der Strahlungshauptseite 20 gegenüberliegenden Seite befindet sich direkt an der Halbleiterschichtenfolge 2 eine Stromaufweitungsschicht 3. Die Stromaufweitungsschicht 3 ist eine AlGaAs-Schicht. Eine Dicke der Stromaufweitungsschicht 3 liegt beispielsweise bei mindestens 120 nm und/oder bei höchstens 500 nm, bevorzugt bei ungefähr 200 nm. Eine Dicke der Halbleiterschichtenfolge 2 beträgt beispielsweise ungefähr 5 µm, wobei ein Bereich zwischen der aktiven Zone 22 und der Strahlungshauptseite 20 eine Dicke von ungefähr 80 % ausmacht.

Anders als dargestellt kann die Stromaufweitungsschicht 3 auch aus mehreren Teilschichten zusammengesetzt sein, beispielsweise aus einer dicken AlGaAs-Schicht und einer dünnen GaAs-Schicht mit einer Dicke von mindestens 2 nm und/oder 10 nm, wobei sich die GaAs-Schicht bevorzugt an einer der Halbleiterschichtenfolge 2 abgewandten Seite der dickeren AlGaAs-Schicht befindet. Eine solche GaAs-Schicht ist bevorzugt auch in allen anderen Ausführungsbeispielen und Abwandlungen vorhanden.

Zur elektrischen Kontaktierung der Stromaufweitungsschicht 3 befindet sich an einer der Halbleiterschichtenfolge 2 abgewandten Seite eine elektrische Kontaktfläche 8. In Figur 1 ist nur eine Kontaktfläche 8 gezeichnet, jedoch liegen bevorzugt mehrere der Kontaktflächen 8 vor, wie auch in allen anderen Ausführungsbeispielen und Abwandlungen. Bei der Kontaktfläche 8 handelt es sich bevorzugt um einen p-Kontakt. Die elektrische Kontaktfläche 8 wird durch eine metallische Kontaktschicht 73 gebildet. Die metallische Kontaktschicht 73 ist bevorzugt aus Gold hergestellt. Ferner sind eine Haftvermittlungsschicht 72 und eine metallische Spiegelschicht 71 vorhanden, bevorzugt eine Goldschicht oder alternativ auch eine Silberschicht. Nachfolgend wird die Spiegelschicht 71 auch als erste Stromleitschicht und die Haftvermittlungsschicht 72 auch als zweite Stromleitschicht bezeichnet. Über die Stromleitschichten 71, 72 ist die elektrische Kontaktfläche 8 elektrisch kontaktiert. Die Stromleitschichten 71, 72 erstrecken sich bevorzugt in lateraler Richtung über den gesamten Leuchtdiodenchip 1 hinweg. Die Spiegelschicht 71 hat beispielsweise eine Dicke von ungefähr 150 nm. Zwischen der Halbleiterschichtenfolge 2 und der Spiegelschicht 71 befindet sich die Haftvermittlungsschicht 72. Bei der Haftvermittlungsschicht 72 handelt es sich bevorzugt um eine ITO-Schicht, etwa mit einer Dicke von ungefähr 100 nm. Durch die Haftvermittlungsschicht 72 ist eine Anhaftung zwischen der Spiegelschicht 71 und der Stromaufweitungsschicht 3 verbessert.

In Richtung weg von der Halbleiterschichtenfolge 2 folgt den Schichten 71, 72 eine Lotschicht 91, beispielsweise ein AuSn-Lot, nach, mittels dessen die Halbleiterschichtenfolge 2 an einem Träger 9 befestigt ist. Über den bevorzugt elektrisch leitfähigen Träger 9 erfolgt eine laterale Stromaufweitung über den Leuchtdiodenchip 1 hinweg, die Schichten 71, 72 dienen vorwiegend lediglich zu einer Stromleitung in Richtung senkrecht zur aktiven Zone 22.

Zwischen den Stromleitschichten 71, 72 und der Stromaufweitungsschicht 3 befindet sich zumindest stellenweise eine Reflexionsschicht 6. Die Reflexionsschicht 6 ist etwa aus Siliziumdioxid oder Siliziumnitrid oder einer Schichtsequenz aus diesen Materialien hergestellt. Eine Dicke der Reflexionsschicht 6 liegt bevorzugt bei mindestens 150 nm oder 200 nm oder 300 nm und/oder bei höchstens 1 µm oder 700 nm oder 600 nm. Die Reflexionsschicht 6 weist unterhalb der gesamten Halbleiterschichtenfolge 2 hinweg eine gleichbleibende, konstante Dicke auf. Neben der Halbleiterschichtenfolge 2 weist die Reflexionsschicht 6 eine reduzierte, gleichmäßig Dicke auf, sodass sich die Verkapselungsschicht 4 zumindest zum Teil seitlich neben der Reflexionsschicht 6, die unter der Halbleiterschichtenfolge 2 liegt, befindet.

Über die Reflexionsschicht 6, die einen vergleichsweise niedrigen optischen Brechungsindex aufweist, wird eine Totalreflexion von in der aktiven Zone 22 erzeugter Strahlung bewirkt. Darüber hinaus wirkt insbesondere die erste Stromleitschicht 71 als metallische Spiegelschicht. Die Reflexionsschicht 6 sowie die beiden Stromleitschichten 71, 72, also die Spiegelschicht 71 und die Haftvermittlungsschicht 72, sind auch in Bereichen lateral neben der Halbleiterschichtenfolge 2 vorhanden, in Draufsicht gesehen. Optional erstreckt sich die zweite Stromleitschicht 72 auch zwischen der ersten Stromleitschicht 71 und der metallischen Kontaktschicht 73, wie in Figur 1 gezeigt.

In einem Randprisma 95 durchdringt die Reflexionsschicht 6 zusammen mit den Stromleitschichten 71, 72 die Stromaufweitungsschicht 3 vollständig und kann auch in die Halbleiterschichtenfolge 2 reichen. Hierdurch werden ein Zentrum 33 und ein in Draufsicht gesehen umlaufender Rand 36 der Stromaufweitungsschicht 3 gebildet. Die eine oder, bevorzugt, die mehreren Kontaktflächen 8 befinden sich in dem Zentrum 33. Der Rand 36 ist elektrisch durch die Reflexionsschicht 6 von dem Zentrum 33 isoliert, da die Halbleiterschichtenfolge 2 im Bereich zwischen der aktiven Zone 22 und der Stromaufweitungsschicht 3 nur eine geringe laterale elektrische Leitfähigkeit aufweist. Somit wird eine Stromeinprägung in die aktive Zone 22 direkt an einer Facette 25 der Halbleiterschichtenfolge 2 unterdrückt.

Zum Schutz der Halbleiterschichtenfolge 2 vor äußeren Einflüssen ist auf allen freiliegenden Flächen sowie auch auf der Reflexionsschicht 6 eine Abdeckschicht 5 aufgebracht. Bei der Abdeckschicht 5 handelt es sich bevorzugt um eine Siliziumnitridschicht, die mit CVD oder PVD aufgebracht ist.

Die Abdeckschicht 5 ist jedoch nicht ausreichend für einen dauerhaften, effizienten Schutz der vergleichsweise feuchtigkeitsanfälligen Stromaufweitungsschicht 3 aus AlGaAs. Daher ist unterhalb der Abdeckschicht 5 eine Verkapselungsschicht 4 erzeugt. Die Verkapselungsschicht 4 ist eine defektarme, hochqualitative Schicht, die mit Atomlagenabscheidung erzeugt ist. Bevorzugt ist die Verkapselungsschicht 4 aus Aluminiumoxid hergestellt, kann alternativ aber auch aus Tantaloxid oder Siliziumdioxid gefertigt sein. Durch die Verkapselungsschicht 4 ist, im Gegensatz zur Abdeckschicht 5, ein ausreichender Schutz der Stromaufweitungsschicht 3 gewährleistet.

Der Leuchtdiodenchip 1 wird insbesondere wie folgt hergestellt:
Die Halbleiterschichtenfolge 2 wird auf einem Aufwachssubstrat, nicht gezeichnet, epitaktisch aufgewachsen. Dabei weist eine Wachstumsrichtung G weg von der Strahlungshauptseite 20. Anschließend wird auf die Halbleiterschichtenfolge 2 die Stromaufweitungsschicht 3 aufgewachsen, wonach die Stromaufweitungsschicht 3 etwa über Ätzen strukturiert wird, sodass das Randprisma 95 erzeugt wird. Anders als dargestellt kann dabei auch ein Material aus der Halbleiterschichtenfolge 2 entfernt werden, sodass dann das Randprisma 95 nicht nur bis an, sondern auch in die Halbleiterschichtenfolge 2 hinein ragen kann, jedoch bevorzugt nicht bis an die aktive Zone 22. Daraufhin werden nacheinander die Reflexionsschicht 6, die Stromleitschichten 71, 72, das Lot 91 und der Träger 9 angebracht.

Daraufhin wird das nicht dargestellte Aufwachssubstrat entfernt. Optional wird eine in Figur 1 nicht gezeichnete Aufrauung an der Strahlungshauptseite 20 erzeugt und ferner optional eine ebenso wenig dargestellte Schutzschicht, etwa aus SiO₂ oder aus Siliziumnitrid, auf die Strahlungshauptseite 20 aufgebracht. Daraufhin wird die Halbleiterschichtenfolge 2 über Ätzen strukturiert, wodurch die Facetten 25 gebildet werden und wobei die Reflexionsschicht 6 im Bereich neben der Halbleiterschichtenfolge 2 in ihrer Dicke reduziert wird. Abschließend werden die Verkapselungsschicht 4 und die Abdeckschicht 5 aufgebracht.

In Figur 2 ist eine Abwandlung eines Leuchtdiodenchips illustriert. Dieser Leuchtdiodenchip weist keine Verkapselungsschicht 4 auf, wie in Verbindung mit Figur 1 dargestellt. Hierdurch ist die Stromaufweitungsschicht 3 nicht hinreichend vor dem Einfluss von Feuchtigkeit geschützt, wodurch eine Lebensdauer des Leuchtdiodenchips reduziert ist.

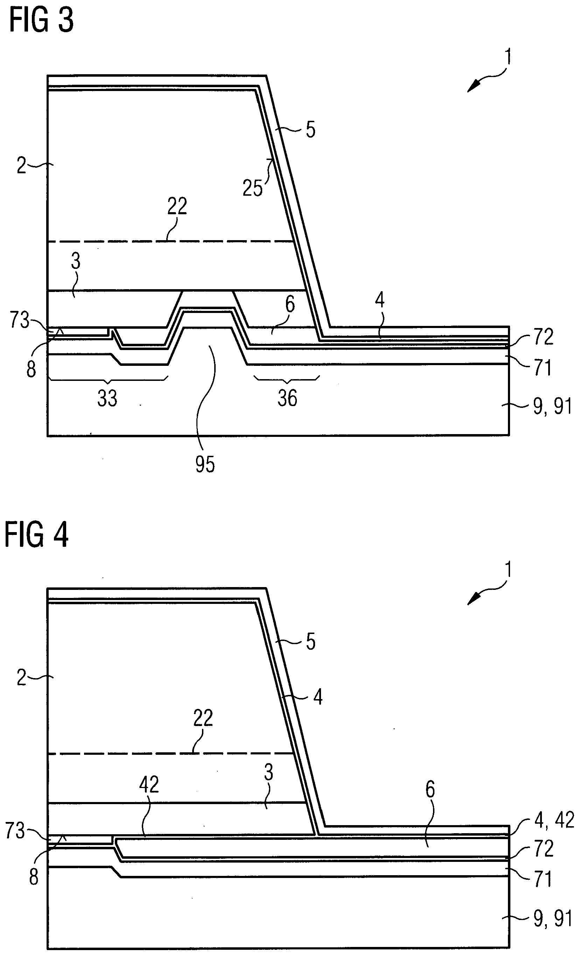

In Figur 3 ist eine weitere Abwandlung gezeigt. Anders als gemäß Figur 1 überragt die Reflexionsschicht 6 die Stromaufweitungsschicht 3 in einer lateralen Richtung nicht oder nicht signifikant. In dem Bereich neben der Stromaufweitungsschicht 3, in Draufsicht gesehen, ist die Reflexionsschicht 6 also vollständig entfernt oder, weniger bevorzugt, in einer reduzierten Dicke noch vorhanden. Das heißt, beim Erzeugen der Facetten 25 und beim Strukturieren der Halbleiterschichtenfolge 2 wird dann auch die Reflexionsschicht 6 durch Ätzen teilweise oder vollständig in dem Bereich neben der Halbleiterschichtenfolge 2 entfernt.

Beim Herstellen des Leuchtdiodenchips 1 gemäß Figur 3 werden nach dem Strukturieren der Halbleiterschichtenfolge 2, der Stromaufweitungsschicht 3 und der Reflexionsschicht 6 dann die Verkapselungsschicht 4 und die Abdeckschicht 5 bevorzugt unmittelbar nacheinander aufgebracht. Somit kann im Bereich neben der Halbleiterschichtenfolge 2 die Verkapselungsschicht 4 direkt auf die zweite Stromleitschicht 72 aufgebracht werden. Hierbei zeigt die Verkapselungsschicht 4 insbesondere aus Aluminiumoxid eine gute Haftung auf ITO, Platin, Chrom, Siliziumdioxid oder Siliziumnitrid auf. Da die Verkapselungsschicht 4 vergleichsweise schlecht auf Gold oder Silber haftet, ist die zweite Stromleitschicht 72 aus ITO im Bereich neben der Halbleiterschichtenfolge 2 bevorzugt noch vorhanden.

Die Reflexionsschicht 6 aus Siliziumdioxid ist vergleichsweise gut durchlässig für Feuchtigkeit. Damit ist, wie in Figur 3 gezeigt, ein verbesserter Schutz der Stromaufweitungsschicht 3 erzielbar, da die Reflexionsschicht 6 auch an einer Seitenfläche von der Verkapselungsschicht 4 bedeckt ist. Hierdurch ist der Transport von H₂O durch die Reflexionsschicht 6 hindurch zu der Stromaufweitungsschicht 3 unterbunden oder zumindest stark reduziert.

Beim Ausführungsbeispiel des Leuchtdiodenchips 1, wie in Figur 4 gezeigt, ist kein Randprisma 95 vorhanden. Die Reflexionsschicht 6 erstreckt sich damit in gleichbleibender Dicke und in einer Ebene liegend von der elektrischen Kontaktfläche 8 bis hin zu einem Rand des Leuchtdiodenchips 1.

Abweichend von Figur 1 ist eine Zusatzverkapselungsschicht 42 vorhanden, bei der es sich ebenfalls um eine mittels Atomlagenabscheidung erzeugte Schicht handelt. Auch die Zusatzverkapselungsschicht 42 ist, wie die Verkapselungsschicht 4, eine Aluminiumoxidschicht. Die Zusatzverkapselungsschicht 42 wird vor der Reflexionsschicht 6 auf die Stromaufweitungsschicht 3 aufgebracht. Somit steht die Stromaufweitungsschicht 3 an keiner Stelle in direktem Kontakt mit der Reflexionsschicht 6 und ist vor Diffusion von Feuchtigkeit durch die Reflexionsschicht 6 hindurch geschützt. Die Zusatzverkapselungsschicht 42 wird bevorzugt ganzflächig auf die noch unstrukturierte Halbleiterschichtenfolge 2 unmittelbar nach dem Erzeugen der Stromaufweitungsschicht 3 aufgebracht.

Im Bereich lateral neben der Halbleiterschichtenfolge 2 ist somit die Verkapselungsschicht 4 direkt auf die Zusatzverkapselungsschicht 42 aufgebracht. Im Gegensatz zur Zusatzverkapselungsschicht 42 wird die Verkapselungsschicht 4 erst nach dem Strukturieren der Halbleiterschichtenfolge 2 erzeugt.

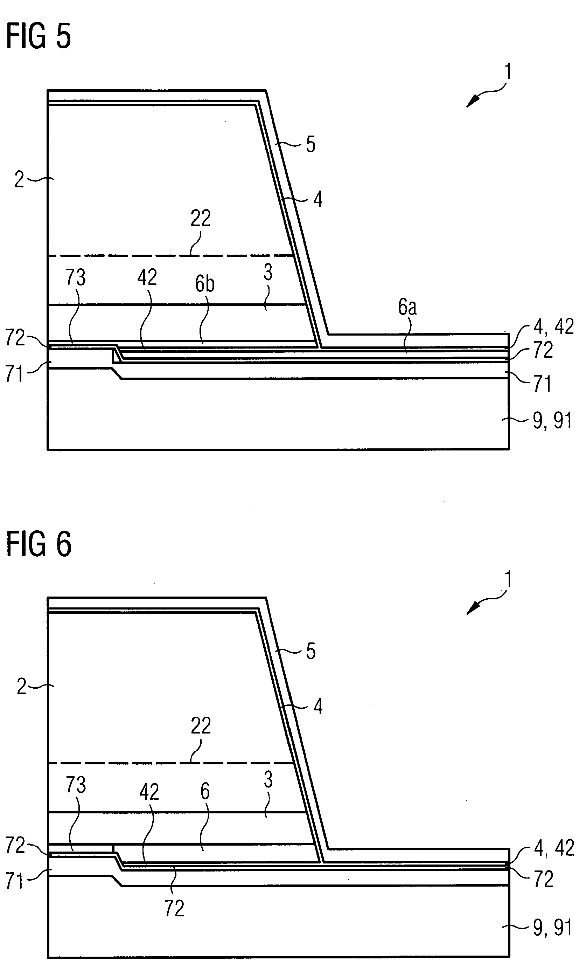

Beim Ausführungsbeispiel der Figur 5 ist die Reflexionsschicht in zwei Teilschichten 6a, 6b aufgeteilt. Direkt an der Stromaufweitungsschicht 3 befindet sich die Teilschicht 6b. Im Bereich neben der Stromaufweitungsschicht 3 wird diese Teilschicht 6b beim Strukturieren der Halbleiterschichtenfolge 2 mit entfernt. Dabei wirkt die Zusatzverkapselungsschicht 42, die bevorzugt eine ALD-Schicht aus Al₂O₃ ist, als Ätzstoppschicht, da dann die Zusatzverkapselungsschicht 42 selektiv gegenüber dem Halbleitermaterial als auch gegenüber SiO₂ der Reflexionsschicht 6b nur schlecht ätzbar ist. Die beiden Teilschichten 6a, 6b sind durch die Zusatzverkapselungsschicht 42 voneinander separiert. Im Bereich neben der Halbleiterschichtenfolge 2 ist damit, wie ebenso in Figur 4, die Verkapselungsschicht 4 unmittelbar auf die Zusatzverkapselungsschicht 42 aufgebracht, sodass in diesem Bereich die Teilschicht 6b vollständig entfernt ist.

Die Teilschicht 6b ist damit seitlich vollständig von der Verkapselungsschicht 4 und an einer der Stromaufweitungsschicht 3 abgewandten Seite vollständig von der Zusatzverkapselungsschicht 42 bedeckt. Damit ist die Teilschicht 6b vollständig eingekapselt und die Stromaufweitungsschicht 3 ist vor Diffusion geschützt. Die beiden Teilschichten 6a, 6b können gleiche oder auch voneinander verschiedene Dicken aufweisen. Beispielsweise ist jede der Teilschichten 6a, 6b zwischen einschließlich 150 nm und 300 nm, insbesondere ungefähr 200 nm, dick. Hierbei kann die Teilschicht 6b dünner gestaltet sein als die Teilschicht 6a und dann eine Dicke von mindestens 25 nm oder 50 nm und/oder von höchstens 80 nm oder 150 nm aufweisen.

Anders als in Figur 5 dargestellt kann auch bei diesem Ausführungsbeispiel ein Randprisma 95 vorhanden sein, analog etwa zu Figur 1.

Die Abwandlung der Figur 6 entspricht dem Ausführungsbeispiel der Figur 3, jedoch ohne das Randprisma 95.

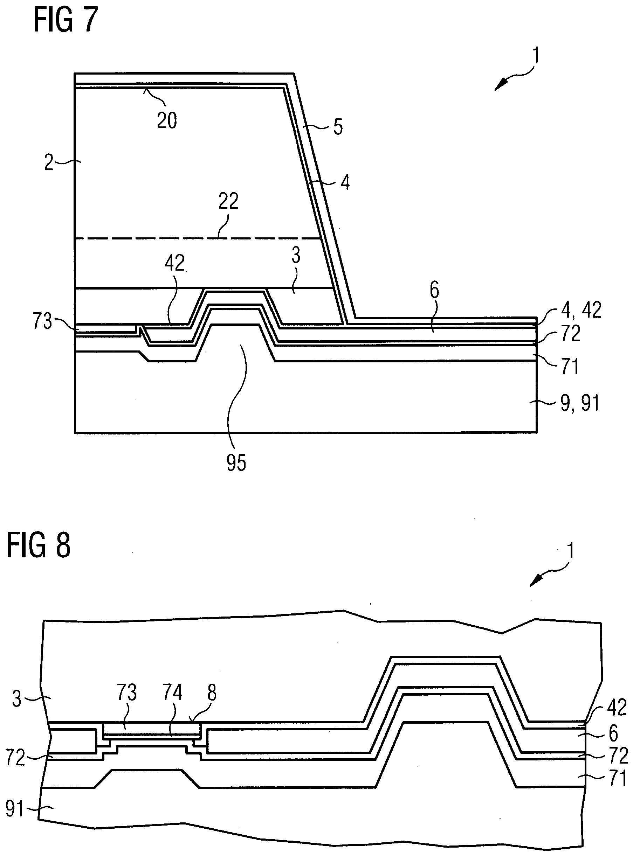

Das Ausführungsbeispiel des Leuchtdiodenchips 1, wie in Figur 7 gezeigt, entspricht dem Ausführungsbeispiel der Figur 4. Jedoch ist in Figur 7 zusätzlich das Randprisma 95 vorhanden.

In Figur 8 ist eine Detailansicht der elektrischen Kontaktfläche 8 gezeigt. Unmittelbar auf die metallische Kontaktschicht 73, die bevorzugt aus Gold ist, ist eine metallische Anhaftschicht 74 aufgebracht, die etwa aus Platin, Chrom, Titan, Nickel oder Titan-Wolfram-Nitrid ist. Eine Dicke der Anhaftschicht 74 liegt beispielsweise bei höchstens 15 nm oder 5 nm. In einem Randbereich der Kontaktfläche 8 folgt der Anhaftschicht 74 die Zusatzverkapselungsschicht 42 nach, gefolgt von der zweiten Stromleitschicht 72, etwa aus ITO, und der ersten Stromleitschicht 71, etwa aus Gold. In einem Zentralbereich der Kontaktfläche 8 ist die Zusatzverkapselungsschicht 42 nicht vorhanden. Ist die als Haftvermittlungsschicht dienende zweite Stromleitschicht 72 aus einem elektrisch isolierenden Material wie Siliziumdioxid gebildet, so ist die Haftvermittlungsschicht 72 in dem Zentralbereich nicht vorhanden. Der Randbereich weist beispielsweise eine Breite von höchstens 10 % einer Gesamtbreite der Kontaktfläche 8 auf. Eine entsprechend gestaltete Kontaktfläche 8 kann auch in allen anderen Ausführungsbeispielen und Abwandlungen vorhanden sein.

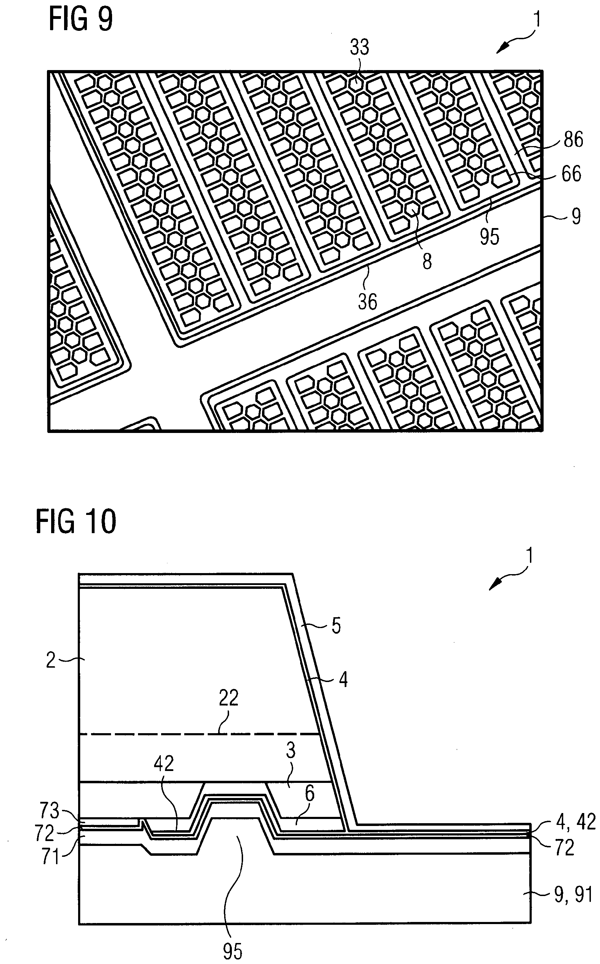

In Figur 9 ist eine schematische Draufsicht auf die Stromaufweitungsschicht 3 von mehreren Leuchtdiodenchips 1 gezeigt, die Schichten 4, 5, 6, 71, 72, 73, 74 sind zur Vereinfachung der Darstellung in Figur 9 nicht gezeichnet. Benachbarte Leuchtdiodenchips 1 sind durch einen unstrukturierten Streifen voneinander separiert. Zu erkennen ist, dass das Randprisma 95 sich rahmenförmig um das gesamte Zentrum 33 mit den Kontaktflächen 8 in einer geschlossenen Bahn herum erstreckt. Ebenso umschließt der Rand 36 vollständig das Randprisma 95. Die Kontaktflächen 8 sind beispielsweise in einem rechteckigen oder, wie in Figur 9 dargestellt, hexagonalen Muster angeordnet.

Optional sind Lichtstreustrukturen 66 vorhanden, die die Kontaktflächen 8 in einem viereckigen Muster umgeben, wobei die Lichtstreustrukturen 66 in Draufsicht gesehen wie ein unregelmäßiges Fünfeck geformt sein können. Zusätzlich sind Streifenwälle 86 vorhanden, die bevorzugt deckungsgleich zu an der Strahlungshauptseite angebrachten Stromaufweitungsstegen, in Figur 9 nicht gezeichnet, verlaufen. Die Lichtstreustrukturen 66 und die Streifenwälle 86 sind bevorzugt analog zu dem Randprisma 95 aufgebaut, sodass in den Lichtstreustrukturen 66 und/oder in den Streifenwällen 86 die Reflexionsschicht 6 bis an oder bis in die Halbleiterschichtenfolge 2 geführt sein kann.

Ein solcher Aufbau mit Randprisma 95 und/oder Lichtstreustruktur 66 und/oder Streifenwällen 86 ist bevorzugt auch in allen anderen Ausführungsbeispielen und Abwandlungen vorhanden.

Die Abwandlung der Figur 10 entspricht der Figur 6, wobei zusätzlich das Randprisma 95 vorhanden ist. Auch gemäß Figur 10 ist eine Seitenfläche 25 der Reflexionsschicht 6 von der Verkapselungsschicht 4 bedeckt und lateral neben der Halbleiterschichtenfolge 2 sind die Verkapselungsschicht 4 und die Zusatzverkapselungsschicht 42 direkt aufeinander und wiederum direkt auf der zweiten Stromleitschicht 72 aufgebracht.

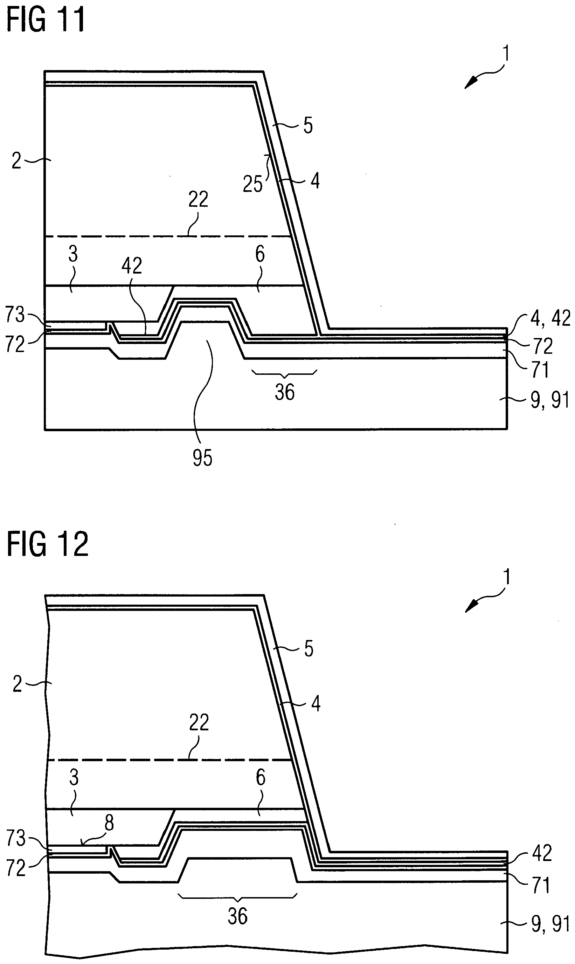

Bei der Abwandlung der Figur 11 reicht die Reflexionsschicht 6, von dem Randprisma 95 ausgehend, bis in Verlängerung der Facette 25 an die Verkapselungsschicht 4 heran. Mit anderen Worten ist die Stromaufweitungsschicht 3 aus dem Randbereich 36 vollständig entfernt und durch die Reflexionsschicht 6 ersetzt.

Auch bei der Abwandlung der Figur 12 ist die Stromaufweitungsschicht 3 nicht mehr in dem Rand 36 vorhanden. Anders als in Figur 11 erstreckt sich die Reflexionsschicht 6 in einer gleichbleibenden Dicke bis hin zur Verkapselungsschicht 4.

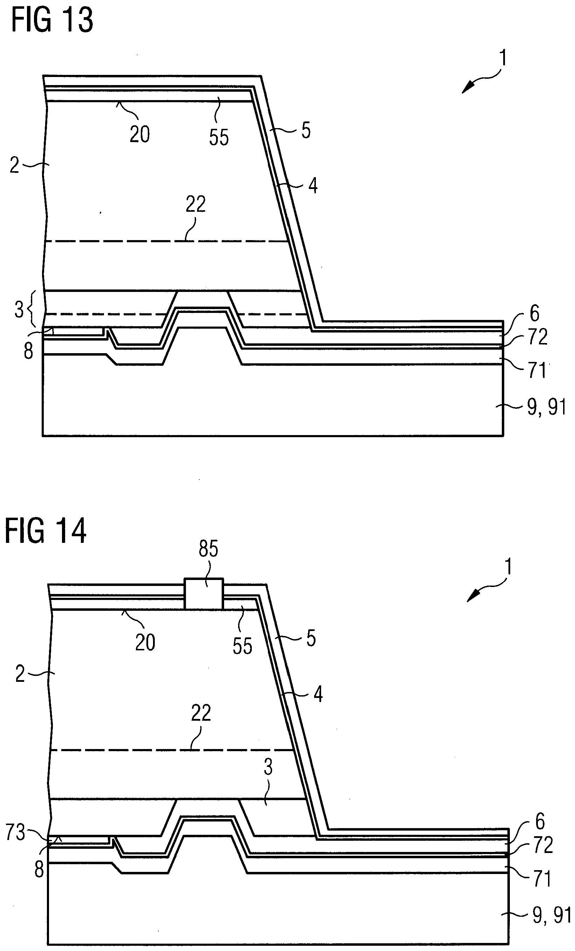

Beim Ausführungsbeispiel der Figur 13 befindet sich direkt an der Strahlungshauptseite 20 eine lichtdurchlässige Schutzschicht 55, etwa aus einem elektrisch isolierenden Material wie SiO₂ oder Siliziumnitrid oder auch aus einem elektrisch leitfähigen Material wie einem dünnen Metall oder einem TCO. Die Strahlungshauptseite 20 ist vollständig von der Schutzschicht 55 bedeckt. Direkt auf die Schutzschicht 55 ist die Verkapselungsschicht 4 angebracht. Eine solche Schutzschicht 55 kann auch in allen anderen Ausführungsbeispielen vorhanden sein.

Die Schutzschicht 55 befindet sich insbesondere an und/oder in einer Aufrauung der Strahlungshauptseite 20. Eine Dicke der Schutzschicht 55 liegt im Falle eines TCOs oder eines elektrisch isolierenden Materials für die Schutzschicht zum Beispiel bei mindestens 40 nm oder 70 nm und/oder bei höchstens 500 nm oder 300 nm. Es ist möglich, dass durch die Schutzschicht 55 eine nicht gezeichnete Aufrauung teilweise oder vollständig planarisiert wird, ebenso wie dies für die Verkapselungsschicht 4 und die Abdeckschicht 5 gelten kann. Optional ist die Stromaufweitungsschicht 3, wie dies auch in allen anderen Ausführungsbeispielen möglich ist, aus mehreren Teilschichten aufgebaut, die in Figur 13 symbolisch durch eine Strichlinie voneinander getrennt sind.

Beim Ausführungsbeispiel der Figur 14 befindet sich direkt an der Strahlungshauptseite 20 ein elektrischer Kontakt 85, bei dem es sich bevorzugt um einen n-Kontakt handelt. Der Kontakt 85 kann aus einem oder aus mehreren Metallen, insbesondere in mehreren Teilschichten, gebildet sein und kann optional ein TCO umfassen. Im Bereich des Kontakts 85 sind die Verkapselungsschicht 4 und die Abdeckschicht 5 sowie die optionale Schutzschicht 55 geöffnet. Ferner liegt der Kontakt 85 eben auf der Strahlungshauptseite 20 auf, sodass die Strahlungshauptseite 20 an dem Kontakt 85 keine Vertiefung aufweist. Der Kontakt 85 überragt die Abdeckschicht 5 und ist bevorzugt dazu vorgesehen, mit einem Bonddraht elektrisch kontaktiert zu werden.

Bei einer Kontaktprozessierung und Herstellung des Kontakts 85 kann die Schutzschicht 85, die als Passivierungsschicht dient, von Vorteil sein, da beim Öffnen der Verkapselungsschicht 4 die Halbleiterschichtenfolge 2 durch die Schutzschicht 4 geschützt ist.

Ausgehend von dem Kontakt 4 können an der Strahlungshauptseite 20 nicht gezeichnete Stromaufweitungsstege vorhanden sein, um eine gleichmäßigere Stromverteilung über den Leuchtdiodenchip 1 hinweg zu erzielen. Solche Stromaufweitungsstege verlaufen bevorzugt deckungsgleich mit den Streifenwällen 86 aus Figur 9.

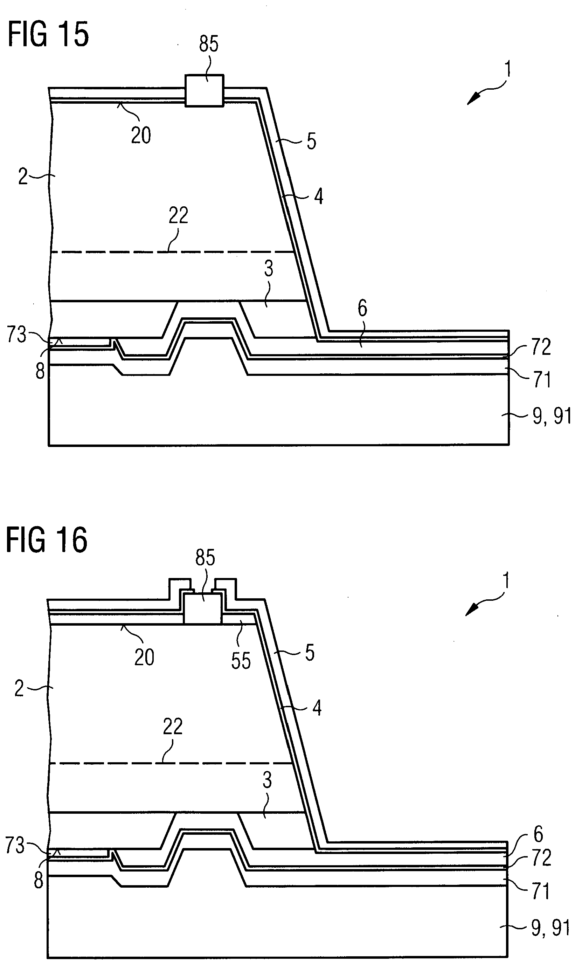

Beim Ausführungsbeispiel der Figur 15 ist die Schutzschicht 55 nicht vorhanden. Dadurch kann es der Fall sein, dass der Kontakt 85 herstellungsbedingt bis in die Halbleiterschichtenfolge 2 hinein ragt.

In Figur 16 ist ein Leuchtdiodenchip 1 gezeigt, bei dem der Kontakt 85 an der n-Seite der Halbleiterschichtenfolge vor dem Aufbringen der Verkapselungsschicht 4 und der Abdeckschicht 5 aufgebracht wird. Hierdurch können mögliche Spalte zwischen der Schutzschicht 55 und dem Kontakt 85 geschlossen werden. Analog zur Kontaktfläche 8 an der Stromaufweitungsschicht 3, vergleiche Figur 8, ist bevorzugt etwa bei Au-Kontakten 85 eine nicht gezeichnete Pt-Haftschicht vorhanden, um die Haftung der Verkapselungsschicht 4 an dem Kontakt 85 sicherzustellen.

Eine Öffnung der Verkapselungsschicht 4 und der Abdeckschicht 5 erfolgt bevorzugt nur an dem Kontakt 85, der auch zum externen elektrischen Kontaktieren etwa mit einem Bonddraht genutzt wird. Falls zum externen elektrischen Kontaktieren erforderlich, kann die Pt-Haftschicht in einem Bondbereich zum Beispiel durch Rücksputtern entfernt werden. Sind Stromaufweitungsstege an der Strahlungshauptseite vorhanden, so wird im Bereich der Stromaufweitungsstege bevorzugt weder die Verkapselungsschicht 4 noch die Abdeckschicht 5 geöffnet. Die Ausführungen mit der Schutzschicht 55 und dem Kontakt 85 der Figuren 13 bis 16 sind exemplarisch nur für den Leuchtdiodenchip 1 der Figur 1 illustriert, können jedoch ebenso auf die Ausführungsbeispiele bzw. Abwandlungen der Figuren 3 bis 11 übertragen werden.
Die hier beschriebene Erfindung ist nicht durch die Beschreibung anhand der Ausführungsbeispiele beschränkt, sondern durch die beigefügten Patentansprüche definiert.

### Bezugszeichenliste

- 1: Leuchtdiodenchip
- 2: Halbleiterschichtenfolge
- 20: Strahlungshauptseite
- 22: aktive Zone
- 25: Facette
- 3: Stromaufweitungsschicht
- 33: Zentrum der Stromaufweitungsschicht
- 36: Rand der Stromaufweitungsschicht
- 4: Verkapselungsschicht
- 42: Zusatzverkapselungsschicht
- 5: Abdeckschicht
- 55: Schutzschicht
- 6: Reflexionsschicht
- 66: Lichtstreustruktur
- 71: Spiegelschicht
- 72: Haftvermittlungsschicht
- 73: metallische Kontaktschicht
- 74: metallische Anhaftschicht
- 8: elektrische Kontaktfläche
- 85: elektrischer Kontakt
- 86: Streifenwall
- 9: Träger
- 91: Lot
- 95: Randprisma

- G: Wachstumsrichtung

## Patentansprüche

1. Leuchtdiodenchip (1) mit
- einer Halbleiterschichtenfolge (2), die auf InGaAlAsP basiert und die zur Erzeugung von sichtbarem Licht oder von nahinfraroter Strahlung eingerichtet ist,
- einer Stromaufweitungsschicht (3), die sich direkt an der Halbleiterschichtenfolge (2) befindet und die auf AlGaAs basiert,
- einer Verkapselungsschicht (4), die stellenweise direkt auf die Stromaufweitungsschicht (3) und/oder auf die Halbleiterschichtenfolge (2) aufgebracht ist und die eine mittlere Dicke zwischen einschließlich 10 nm und 200 nm sowie eine Defektdichte von höchstens 10/mm² aufweist,
- zumindest einer Abdeckschicht (5), die wenigstens stellenweise direkt auf die Verkapselungsschicht (4) aufgebracht ist,
- zumindest einer nichtmetallischen Reflexionsschicht (6), die sich stellenweise an einer der Halbleiterschichtenfolge (2) abgewandten Seite der Stromaufweitungsschicht (3) befindet und die stellenweise von der Verkapselungsschicht (4) bedeckt ist, und
- zumindest einer Spiegelschicht (71) und/oder einer Haftvermittlungsschicht (72), die sich stellenweise an einer der Stromaufweitungsschicht (3) abgewandten Seite der Reflexionsschicht (6) befindet und zur Bestromung einer elektrischen Kontaktfläche (8) eingerichtet ist, wobei
- die Abdeckschicht (5) eine größere mittlere Dicke aufweist als die Verkapselungsschicht (4),
- die Verkapselungsschicht (4) äußere Facetten (25) der Stromaufweitungsschicht (3) vollständig und direkt bedeckt, und
- die Stromaufweitungsschicht (3) und die Halbleiterschichtenfolge (2) von der Reflexionsschicht (6) seitlich überragt werden, in Draufsicht gesehen, und die Verkapselungsschicht (4) auf die Stromaufweitungsschicht (3) überragende Teilgebiete der Reflexionsschicht (6) direkt aufgebracht ist.

2. Leuchtdiodenchip (1) nach dem vorhergehenden Anspruch, bei dem die Verkapselungsschicht (4) eine Al₂O₃-Schicht ist.

3. Leuchtdiodenchip (1) nach einem der vorhergehenden Ansprüche,
bei dem direkt an einer der Halbleiterschichtenfolge (2) abgewandten Seite der Stromaufweitungsschicht (3) eine Zusatzverkapselungsschicht (42) aufgebracht ist, die aus demselben Material hergestellt ist wie die Verkapselungsschicht (4).

4. Leuchtdiodenchip (1) nach dem vorhergehenden Anspruch, bei dem die Zusatzverkapselungsschicht (42) die Verkapselungsschicht (4) stellenweise berührt,
wobei ein Berührbereich der Zusatzverkapselungsschicht (42) mit der Verkapselungsschicht (4) dicht verschlossen ist.

5. Leuchtdiodenchip (1) nach einem der beiden vorhergehenden Ansprüche,
bei dem die Reflexionsschicht (6) an keiner Stelle in direktem Kontakt mit der Halbleiterschichtenfolge (2) oder der Stromaufweitungsschicht (3) steht,
wobei die Halbleiterschichtenfolge (2) und die Stromaufweitungsschicht (3) ringsum vollständig von der Verkapselungsschicht (4) zusammen mit der Zusatzverkapselungsschicht (42) und der wenigstens einen metallischen, elektrischen Kontaktfläche (8) eingeschlossen ist.

6. Leuchtdiodenchip (1) nach einem der Ansprüche 3 bis 5, bei dem die Reflexionsschicht (6) zumindest stellenweise in zwei Teilschichten (6a, 6b) aufgeteilt ist, die entlang einer Wachstumsrichtung (G) der Halbleiterschichtenfolge (2) aufeinanderfolgen, wobei sich zwischen den zwei Teilschichten (6a, 6b) die Verkapselungsschicht (4) und/oder die Zusatzverkapselungsschicht (42) befindet.

7. Leuchtdiodenchip (1) nach einem der Ansprüche 3 bis 6, bei dem die Verkapselungsschicht (4) und/oder die Zusatzverkapselungsschicht (42) eine Ätzstoppschicht für die Stromaufweitungsschicht (3) und/oder die Reflexionsschicht (6) bildet, sodass die Stromaufweitungsschicht (3) gegenüber der Verkapselungsschicht (4) und/oder der Zusatzverkapselungsschicht (42) selektiv ätzbar ist.

8. Leuchtdiodenchip (1) nach einem der vorhergehenden Ansprüche,
bei dem die Reflexionsschicht (6) die Stromaufweitungsschicht (3) stellenweise vollständig durchdringt, sodass in Draufsicht gesehen die Stromaufweitungsschicht (3) einen äußeren, umlaufenden Rand (36) aufweist, der durch die Reflexionsschicht (6) von einem Zentrum (33) der Stromaufweitungsschicht (3), in dem sich der mindestens eine elektrische Kontaktbereich (8) befindet, elektrisch isoliert ist.

9. Leuchtdiodenchip (1) nach einem der Ansprüche 1 bis 4, bei dem die Reflexionsschicht (6) um die Stromaufweitungsschicht (3) herum, in Draufsicht gesehen, einen umlaufenden Rand (36) bildet und in diesem Rand die Reflexionsschicht (6) direkt an die Halbleiterschichtenfolge (2) grenzt,
wobei der Rand (36) eine Breite von mindestens 3 µm und von höchstens 15 µm aufweist.

10. Leuchtdiodenchip (1) nach einem der vorhergehenden Ansprüche, bei dem
- die Stromaufweitungsschicht (3) aus einer GaAs-Teilschicht und mindestens einer AlGaAs-Teilschicht zusammengesetzt ist,
- die Reflexionsschicht (6) aus SiO₂ ist,
- eine erste Stromleitschicht als Spiegelschicht (71) aus Gold und eine zweite Stromleitschicht als Haftvermittlungsschicht (72) aus Indium-Zinn-Oxid vorhanden sind, die direkt aufeinander aufgebracht sind, wobei sich die zweite Stromleitschicht (72) im Mittel näher an der Stromaufweitungsschicht (3) befindet und die zwei Stromleitschichten (71, 72) die Stromaufweitungsschicht (3) seitlich überragen,
- die Abdeckschicht (5) aus Siliziumnitrid ist, und
- sich an einer der Halbleiterschichtenfolge (2) abgewandten Seite der ersten Stromleitschicht (71) ein Träger (9) des Leuchtdiodenchips (1) befindet, der über zumindest ein Lot (91) an den Stromleitschichten (71, 72) befestigt ist.

11. Leuchtdiodenchip (1) nach einem der vorhergehenden Ansprüche,
bei dem sich direkt an einer der
Halbleiterschichtenfolge (2) abgewandten Seite der Stromaufweitungsschicht (3) zumindest ein elektrischer Kontaktbereich mit einem Zentralbereich und einem Randbereich befindet und der elektrische Kontaktbereich die elektrische Kontaktfläche (8) umfasst,
wobei in dem Zentralbereich die folgenden Schichten in der angegebenen Reihenfolge direkt aufeinander folgen: die Stromaufweitungsschicht (3), eine metallische Kontaktschicht (73), eine metallische Anhaftschicht (74), die Spiegelschicht (71), und
wobei in dem Randbereich die folgenden Schichten in der angegebenen Reihenfolge direkt aufeinander folgen: die Stromaufweitungsschicht (3), die Kontaktschicht (73), die Anhaftschicht (74), die Zusatzverkapselungsschicht (42), die Haftvermittlungsschicht (72), die Spiegelschicht (71).

12. Verfahren, mit dem ein Leuchtdiodenchip (1) nach einem der vorherigen Ansprüche hergestellt wird,
wobei die Verkapselungsschicht (4) mittels Atomlagenabscheidung hergestellt wird,
wobei die Abdeckschicht (5) mittels chemischer oder physikalischer Gasphasenabscheidung und nicht durch Atomlagenabscheidung hergestellt wird.

## Claims

1. Light-emitting diode chip (1) comprising
- a semiconductor layer sequence (2) which is based on InGaAlAsP and which is configured for the generation of visible light or near-infrared radiation,
- a current spreading layer (3) which is located directly on the semiconductor layer sequence (2) and which is based on AlGaAs,
- an encapsulation layer (4) which is applied in places directly to the current spreading layer (3) and/or to the semiconductor layer sequence (2) and which comprises an average thickness between 10 nm and 200 nm inclusive and a defect density of at most 10/mm²,
- at least one cover layer (5) which is applied in places directly to the encapsulation layer (4),
- at least one non-metallic reflection layer (6) which is located in places on a side of the current spreading layer (3) facing away from the semiconductor layer sequence (2) and which is covered in places by the encapsulation layer (4), and
- at least one mirror layer (71) and/or at least one adhesion-promoting layer (72), which is located in places on a side of the reflection layer (6) facing away from the current spreading layer (3) and is configured for energizing an electrical contact surface (8), wherein
- the cover layer (5) comprises a greater average thickness than the encapsulation layer (4),
- the encapsulation layer (4) completely and directly covers outer facets (25) of the current spreading layer (3), and
- the current spreading layer (3) and the semiconductor layer sequence (2) are laterally protruded by the reflection layer (6), seen in plan view, and the encapsulation layer (4) is directly applied to regions of the reflection layer (6) protruding the current spreading layer (3).

2. Light-emitting diode chip (1) according to the preceding claim,
wherein the encapsulation layer (4) is an Al₂O₃ layer.

3. Light-emitting diode chip (1) according to one of the preceding claims,
wherein an additional encapsulation layer (42) is applied directly to a side of the current spreading layer (3) facing away from the semiconductor layer sequence (2), which additional encapsulation layer (42) is made of the same material as the encapsulation layer (4) .

4. Light-emitting diode chip (1) according to the preceding claim,
wherein the additional encapsulation layer (42) contacts the encapsulation layer (4) in places,
wherein a contact region of the additional encapsulation layer (42) with the encapsulation layer (4) is sealed.

5. Light-emitting diode chip (1) according to one of the two preceding claims,
wherein the reflection layer (6) is not in direct contact with the semiconductor layer sequence (2) or the current spreading layer (3) at any point,
wherein the semiconductor layer sequence (2) and the current spreading layer (3) are completely enclosed all around by the encapsulation layer (4) together with the additional encapsulation layer (42) and the at least one metallic electrical contact surface (8).

6. Light-emitting diode chip (1) according to one of claims 3 to 5,
wherein the reflection layer (6) is divided, at least in places, into two partial layers (6a, 6b) which follow one another along a growth direction (G) of the semiconductor layer sequence (2),
wherein the encapsulation layer (4) and/or the additional encapsulation layer (42) is located between the two partial layers (6a, 6b).

7. Light-emitting diode chip (1) according to one of claims 3 to 6,
wherein the encapsulation layer (4) and/or the additional encapsulation layer (42) forms an etch stop layer for the current spreading layer (3) and/or the reflection layer (6), such that the current spreading layer (3) is selectively etchable relative to the encapsulation layer (4) and/or the additional encapsulation layer (42).

8. Light-emitting diode chip (1) according to one of the preceding claims,
wherein the reflection layer (6) completely penetrates the current spreading layer (3) in places, so that, as seen in plan view, the current spreading layer (3) comprises an outer, circumferential edge (36) which is electrically insulated by the reflection layer (6) from a center (33) of the current spreading layer (3) in which the at least one electrical contact region (8) is located.

9. Light-emitting diode chip (1) according to one of claims 1 to 4,
wherein the reflection layer (6) forms a circumferential edge (36) around the current spreading layer (3), as seen in plan view, and in this edge the reflection layer (6) directly adjoins the semiconductor layer sequence (2) ,
wherein the edge (36) comprises a width of at least 3 µm and of at most 15 µm.

10. Light-emitting diode chip (1) according to one of the preceding claims, in which
- the current spreading layer (3) is composed of a GaAs partial layer and at least one AlGaAs partial layer,
- the reflection layer (6) is made of SiO₂,
- a first current conducting layer as mirror layer (71) of gold and a second current conducting layer as adhesion-promoting layer (72) of indium tin oxide are present, which are applied directly to one another, wherein the second current conducting layer (72) is located on average closer to the current spreading layer (3) and the two current conducting layers (71, 72) project laterally beyond the current spreading layer (3),
- the cover layer (5) is made of silicon nitride, and
- a carrier (9) of the light-emitting diode chip (1) is located on a side of the first current conducting layer (71) facing away from the semiconductor layer sequence (2), which carrier is attached to the current conducting layers (71, 72) via at least one solder (91).

11. Light-emitting diode chip (1) according to one of the preceding claims,
wherein at least one electrical contact region with a central region and an edge region is located directly on a side of the current spreading layer (3) facing away from the semiconductor layer sequence (2), and the electrical contact region comprises the electrical contact surface (8),
wherein in the central region the following layers directly follow one another in the order indicated: the current spreading layer (3), a metallic contact layer (73), a metallic adhesion layer (74), the mirror layer (71), and
wherein, in the edge region, the following layers directly follow one another in the order indicated: the current spreading layer (3), the contact layer (73), the adhesion layer (74), the additional encapsulation layer (42), the adhesion-promoting layer (72), the mirror layer (71).

12. Method by which a light-emitting diode chip (1) according to one of the preceding claims is produced, wherein the encapsulation layer (4) is produced by means of atomic layer deposition,
wherein the cover layer (5) is produced by chemical or physical vapor deposition and not by atomic layer deposition.

## Revendications

1. Puce de diode électroluminescente (1) comprenant
- une succession de couches semi-conductrices (2) à base d'InGaAlAsP et conçue pour générer de la lumière visible ou un rayonnement proche de l'infrarouge,
- une couche d'expansion de courant (3) située directement sur la succession de couches semi-conductrices (2) et à base d'AlGaAs,
- une couche d'encapsulation (4) appliquée par endroits directement sur la couche d'expansion de courant (3) et/ou sur la succession de couches semi-conductrices (2) et présentant une épaisseur moyenne comprise entre 10 nm et 200 nm inclus, ainsi qu'une densité de défauts de 10/mm² au maximum,
- au moins une couche de revêtement (5) appliquée directement au moins par endroits sur la couche d'encapsulation (4),
- au moins une couche réfléchissante non métallique (6) située par endroits sur un côté de la couche d'expansion de courant (3) opposé à la succession de couches semi-conductrices (2) et recouverte par endroits par la couche d'encapsulation (4), et
- au moins une couche miroir (71) et/ou une couche conférant de l'adhérence (72), située par endroits sur un côté de la couche réfléchissante (6) opposé à la couche d'expansion du courant (3) et conçue pour alimenter une surface de contact électrique (8), dans laquelle
- la couche de revêtement (5) présente une épaisseur moyenne supérieure à celle de la couche d'encapsulation (4),
- la couche d'encapsulation (4) recouvre entièrement et directement les facettes extérieures (25) de la couche d'expansion de courant (3), et
- la couche d'expansion de courant (3) et la succession de couches semi-conductrices (2) sont recouvertes latéralement par la couche réfléchissante (6), vue en plan, et la couche d'encapsulation (4) est appliquée directement sur les zones partielles de la couche réfléchissante (6) recouvrant la couche d'expansion de courant (3).

2. Puce de diode électroluminescente (1) selon la revendication précédente,
dans laquelle la couche d'encapsulation (4) est une couche d'Al₂O₃.

3. Puce de diode électroluminescente (1) selon l'une des revendications précédentes,
dans laquelle une couche d'encapsulation supplémentaire (42), fabriquée à partir du même matériau que la couche d'encapsulation (4), est appliquée directement sur un côté de la couche d'expansion de courant (3) opposé à la succession de couches semi-conductrices (2).

4. Puce de diode électroluminescente (1) selon la revendication précédente,
dans laquelle la couche d'encapsulation supplémentaire (42) est en contact avec la couche d'encapsulation (4) à certains endroits,
une zone de contact de la couche d'encapsulation supplémentaire (42) étant hermétiquement scellée par la couche d'encapsulation (4).

5. Puce de diode électroluminescente (1) selon l'une des deux revendications précédentes,
dans laquelle la couche réfléchissante (6) n'est en aucun point en contact direct avec la succession de couches semi-conductrices (2) ou la couche d'expansion de courant (3),
la succession de couches semi-conductrices (2) et la couche d'expansion de courant (3) étant entièrement scellées par la couche d'encapsulation (4) associée à la couche d'encapsulation supplémentaire (42) et au moins une surface de contact électrique métallique (8).

6. Puce de diode électroluminescente (1) selon l'une des revendications 3 à 5,
dans laquelle la couche réfléchissante (6) est divisée, au moins par endroits, en deux couches partielles (6a, 6b) qui se succèdent le long d'une direction de croissance (G) de la succession de couches semi-conductrices (2),
dans laquelle la couche d'encapsulation (4) et/ou la couche d'encapsulation supplémentaire (42) est/sont située(s) entre les deux couches partielles (6a, 6b).

7. Puce de diode électroluminescente (1) selon l'une des revendications 3 à 6,
dans laquelle la couche d'encapsulation (4) et/ou la couche d'encapsulation supplémentaire (42) forme(nt) une couche d'arrêt de gravure pour la couche d'expansion de courant (3) et/ou la couche réfléchissante (6), de sorte que la couche d'expansion de courant (3) peut être gravée sélectivement par rapport à la couche d'encapsulation (4) et/ou la couche d'encapsulation supplémentaire (42).

8. Puce de diode électroluminescente (1) selon l'une des revendications précédentes,
dans laquelle la couche réfléchissante (6) pénètre complètement par endroits dans la couche d'expansion de courant (3), de sorte que, vue en plan, la couche d'expansion de courant (3) présente un bord périphérique extérieur (36) qui est électriquement isolé par la couche réfléchissante (6) d'un centre (33) de la couche d'expansion de courant (3), dans lequel se trouve au moins une zone de contact électrique (8).

9. Puce de diode électroluminescente (1) selon l'une des revendications 1 à 4,
dans laquelle la couche réfléchissante (6) forme, dans une vue en plan, un bord périphérique (36) autour de la couche d'expansion de courant (3), dans lequel la couche réfléchissante (6) est directement adjacente à la succession de couches semi-conductrices (2), le bord (36) présentant une largeur d'au moins 3 µm et d'au plus 15 µm.

10. Puce de diode électroluminescente (1) selon l'une des revendications précédentes, dans laquelle
- la couche d'expansion de courant (3) est composée d'une sous-couche de GaAs et d'au moins une sous-couche d'AlGaAs,
- la couche réfléchissante (6) est constituée de SiO₂,
- une première couche conductrice de courant comme couche miroir (71) en or et une deuxième couche conductrice de courant comme couche conférant de l'adhérence (72) en oxyde d'indium-étain sont présentes et appliquées directement l'une sur l'autre, la deuxième couche conductrice de courant (72) étant située en moyenne plus près de la couche d'expansion de courant (3) et les deux couches conductrices de courant (71, 72) dépassant latéralement de la couche d'expansion de courant (3),
- la couche de revêtement (5) est en nitrure de silicium, et
- un support (9) de la puce à diode électroluminescente (1) est situé sur un côté de la première couche conductrice de courant (71) opposé à la succession de couches semi-conductrices (2), ce support étant fixé par au moins une soudure (91) aux couches conductrices de courant (71, 72).

11. Puce de diode électroluminescente (1) selon l'une des revendications précédentes,
dans laquelle au moins une zone de contact électrique comportant une zone centrale et une zone de délimitation est située directement sur un côté de la couche d'expansion de courant (3) opposé à la succession de couches semi-conductrices (2), et la zone de contact électrique comprend la surface de contact électrique (8),
les couches suivantes se succédant directement dans l'ordre donné dans la zone centrale : la couche d'expansion de courant (3), une couche de contact métallique (73), une couche d'adhérence métallique (74), la couche miroir (71), et
les couches suivantes se succédant directement dans l'ordre donné dans la zone de délimitation : la couche d'expansion de courant (3), la couche de contact (73), la couche d'adhérence (74), la couche d'encapsulation supplémentaire (42), la couche conférant de l'adhérence (72), la couche miroir (71).

12. Procédé de fabrication d'une puce à diode électroluminescente (1) selon l'une des revendications précédentes,
dans lequel la couche d'encapsulation (4) est produite par dépôt de couches atomiques,
dans lequel la couche de revêtement (5) est produite par dépôt chimique ou physique en phase vapeur et non par dépôt de couches atomiques.
